# EUROPEAN PATENT APPLICATION

(11) **EP 3 651 274 A1**
(43) Date of publication of application: **13.05.2020**
(21) Application number: 18843981.4
(22) Date of filing: 01.06.2018
(51) Int. Cl.: H01R 12/71

(54) **SOCKET STRUCTURE FOR BICYCLE LOCK CIRCUIT BOARD OF SHARED BICYCLE**

(30) Priority: 07.08.2017 CN 201720978628 U; 06.02.2018 CN 201820205922 U
(71) Applicant: Hangzhou Qingqi Science And Technology Co., Ltd., Zhejiang 311100 (CN)
(72) Inventor: LI, Gang, Hangzhou Zhejiang 311100 (CN); HU, Weisheng, Hangzhou Zhejiang 311100 (CN); CAI, Shenghong, Hangzhou Zhejiang 311100 (CN); LI, Zaixing, Hangzhou Zhejiang 311100 (CN); LIU, Sheng, Hangzhou Zhejiang 311100 (CN)
(74) Representative: Wang, Bo
(86) International application number: PCT/CN2018/089636
(87) International publication number: WO 2019/029244

(57) **Abstract**

The present disclosure relates to the field of shared bicycles, and in particular, to a socket structure of a lock circuit board of a shared bicycle. The lock circuit board may be disposed in a lock control box, and connected to a power source, a lock motor, a first pressure sensor, and a second pressure sensor via wires respectively. The socket structure may include a control socket, a signal transmission socket, and a power socket disposed on the lock circuit board. The control socket may be configured to connect the lock motor to a control line of the lock circuit board. The power socket may be configured to connect the power source to a power input of the lock circuit board. The signal transmission socket may be configured to connect the lock circuit board to the first pressure sensor and the second pressure sensor, respectively. The present disclosure may provide the socket structure of the lock circuit board of the shared bicycle wherein a connected between the lock circuit board and external component(s) may be established using the socket structure instead of a conventional welding connection. The lock circuit board may be directly inserted into the socket structure for installation, thereby improving the installation efficiency.

## Description

### CROSS-REFERENCE TO RELATED APPLICATIONS

This application claims priority to Chinese Patent Application No. 201820205922.X, filed on February, 6, 2018, Chinese Patent Application No. 201720978628.8, filed on August 7, 2017, the contents of each of which are hereby incorporated by reference.

### TECHNICAL FIELD

The present disclosure generally relates to the field of shared bicycles, and in particular, to a socket structure of a lock circuit board of a shared bicycle.

### BACKGROUND

With the development of the Internet era, shared transportations, such as a shared bicycle, a shared car, have been rapidly popularized. The shared transportations may meet travelling needs of general people, and be widely welcomed by people. The shared transportations may play an increasingly important role in people's lives.

The production and maintenance of the shared transportations, for example, the shared bicycle, may not keep up with the increasing needs of people. How to improve the production efficiency and maintenance efficiency of the shared bicycle may be a major issue that needs to be solved.

### SUMMARY

To solve the above-mentioned technical issue, the present disclosure may provide a socket structure of a lock circuit board of a shared bicycle, thereby improving the production efficiency and the maintenance efficiency.

The present disclosure may adopt the following technical solutions to solve the technical issue. The present disclosure may provide the socket structure of the lock circuit board of the shared bicycle. The lock circuit board may be disposed in a lock control box, and connected to a power source, a lock motor, a first pressure sensor, and a second pressure sensor via wires respectively. The socket structure may include a control socket, a signal transmission socket, and a power socket disposed on the lock circuit board. The control socket may be configured to connect the lock motor to a control line of the lock circuit board. The power socket may be configured to connect the power source to a power input of the lock circuit board. The signal transmission socket may be configured to connect the lock circuit board to the first pressure sensor and the second pressure sensor, respectively.

In some preferred technical solutions, the signal transmission socket may include a first signal transmission socket and a second signal transmission socket. The first pressure sensor may include a first connection wire. One end of the first connection wire may have a jack matching the first signal transmission socket. The first pressure sensor may be connected with the first signal transmission socket via the jack of the first connection wire. The second pressure sensor may include a second connection wire. One end of the second connection wire may have a jack matching the second signal transmission socket. The second pressure sensor may be connected with the second signal transmission socket via the jack of the second connection wire.

In some preferred technical solutions, the first pressure sensor may include a first connection wire. The second pressure sensor may include a second connection wire. An end of each of the first connection wire and the second connection wire may be connected to a jack matching the signal transmission socket.

In some preferred technical solutions, a sensor signal acquisition module of the lock circuit board may be connected to a corresponding pin of the signal transmission socket via a lead wire.

In some preferred technical solutions, the lock motor, the first pressure sensor, and the second pressure sensor may be disposed at a front end of the lock control box. The lock circuit board may be vertically disposed at the middle end of the lock control box. The power source may include a battery pack disposed at a rear end of the lock control box. The control socket and the signal transmission socket may be disposed on a front surface of the lock circuit board. The power socket may be disposed on a rear surface of the lock circuit board.

In some preferred technical solutions, the socket structure may further include a solar socket disposed on the front surface of the lock circuit board. The solar socket may be connected to an external solar panel. The solar socket may be connected to a power management module of the lock circuit board. The power management module may be connected to a battery and configured to power the battery using an electric power of the solar panel.

In some preferred technical solutions, the solar socket may further include a signal transmission pin connected to a main control chip of the lock circuit board. The solar battery and a detection line may share a data line. An end of the data line may include a jack that matches the solar socket.

The present disclosure may provide the following beneficial effects. Compared with conventional technical solutions in the prior art, the present disclosure may provide the socket structure of the lock circuit board of the shared bicycle wherein a connection between the lock circuit board and external component(s) may be established using the socket structure instead of a conventional welding connection. The lock circuit board may be directly inserted into the socket structure for installation, thereby improving the installation efficiency. Connection line(s) of the lock circuit board may be directly removed during maintenance, thereby improving maintenance efficiency. At the same time, the connection may be more stable.

### BRIEF DESCRIPTION OF THE DRAWINGS

The present disclosure is further described in terms of exemplary embodiments. These exemplary embodiments are described in detail with reference to the drawings, wherein:
FIG. 1 is a schematic diagram illustrating an exemplary socket structure according to the present disclosure;
FIG. 2 is schematic diagram illustrating the socket structure in FIG. 1 viewed from a vertical direction;
FIG. 3 is a schematic diagram illustrating an exemplary lock control box according to the present disclosure;
FIG. 4 is a block diagram illustrating an exemplary module connection of a socket structure according to the present disclosure; and
FIG. 5 is a block diagram illustrating an exemplary module connection of a solar socket according to the present disclosure.

### DETAILED DESCRIPTION

Preferred embodiments of the present disclosure will be described in detail with reference to the drawings.

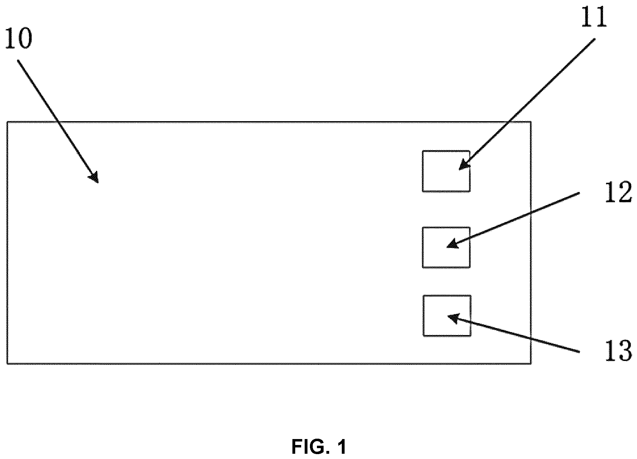

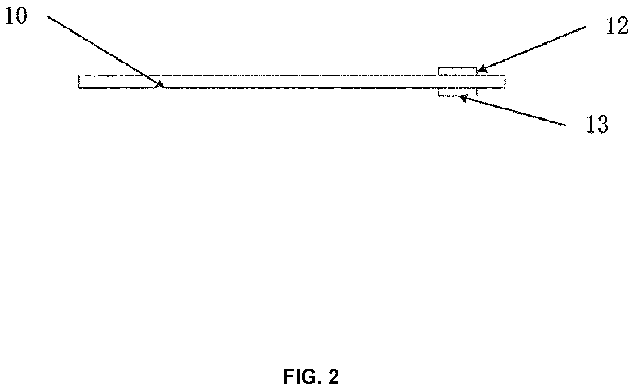

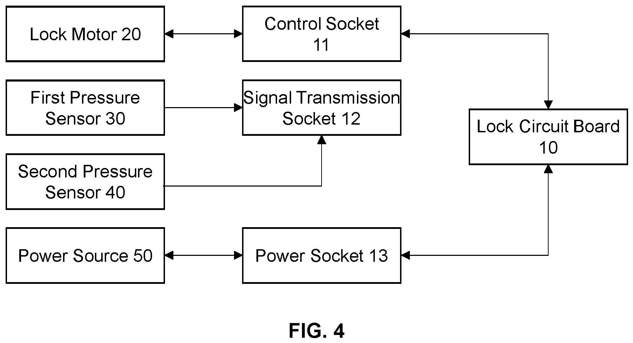

As illustrated in FIGs. 1 to 4, the present disclosure provides preferred embodiments of a socket structure of a lock circuit board 10 of a shared bicycle.

In the socket structure of the lock circuit board 10 of the shared bicycle, the lock circuit board 10 may be disposed in a lock control box, and connected to a power source 50, a lock motor 20, a first pressure sensor 30, and a second pressure sensor 40 via wires, respectively. The socket structure may include a control socket 11, a signal transmission socket 12, a power source 50, and a power socket 13 disposed on the lock circuit board 10. The control socket 11 may be configured to connect the lock motor 20 to a control line of the lock circuit board 10. The power source 50 socket 13 may be configured to connect the power source 50 to a power input of the lock circuit board 10. The signal transmission socket 12 may be configured to connect the lock circuit board 10 to the first pressure sensor 30 and the second pressure sensor 40, respectively.

The power source 50 may include a multi-layer integrated battery, which may store more electrical power, improve the sustainable service life of the shared bicycle, and reduce the maintenance cost of the shared bicycle.

The lock control box may include a sealed and waterproof housing. The lock circuit board 10, the power source 50, the lock motor 20, the first pressure sensor 30, and the second pressure sensor 40 may be disposed in the lock control box to improve the overall safety and protect them from damaging.

In some embodiments, the structure of the lock motor 20, the first pressure sensor 30, and the second pressure sensor 40 in the lock control box may include the following structure. The lock control box may include a position-limiting lever that is configured to limit a position of the lock of the shared bicycle when the lock of the shared bicycle is in a locked state. The position-limiting lever may be integrated into the lock of the shared bicycle lock when the lock of the shared bicycle is in the locked state. The lock motor 20 may be configured to guide a movement of the position-limiting lever. When the position-limiting lever is removed, the lock may be retracted due to an elastic effect, and the lock may be unlocked. When the position-limiting lever is inserted, the lock may be locked and limited. The remove of the position-limiting lever may be merely controlled by the lock motor 20, and the insertion of the position-limiting lever may be performed by a spring disposed at one end of the position-limiting lever.

Furthermore, a first rod and a second rod of the position-limiting lever may extend outward. The first rod may contact the first pressure sensor 30 when the position-limiting lever is removed, and the first pressure sensor 30 may generate a sensing signal. The second rod may contact the second pressure sensor 30 when the position-limiting lever is inserted, and the second pressure sensor 30 may generate a sensing signal.

Two structures of the signal transmission socket 12 are provided according to some embodiments.

### Embodiment 1

The signal transmission socket 12 may include a first signal transmission socket 12 and a second signal transmission socket 12. The first pressure sensor 30 may include a first connection wire. One end of the first connection wire may have a jack matching the first signal transmission socket 12. The first pressure sensor 30 may be connected to the first signal transmission socket 12 via the jack of the first connection wire. The second pressure sensor 40 may include a second connection wire. One end of the second connection wire may have a jack matching the second signal transmission socket 12. The second pressure sensor 40 may be connected to the second signal transmission socket 12 via the jack of the second connection wire.

Specifically, the lock circuit board 10 may include a processing chip. The processing chip may be connected to the first signal transmission socket 12 and the second signal transmission socket 12 disposed on the lock circuit board 10 via a lead wire of the lock circuit board 10. That is, a signal transmission pin of the processing chip may be connected to a signal transmission pin of the first signal transmission socket 12. The signal transmission pin of the processing chip may be connected to a signal transmission pin of the second signal transmission socket 12. If the first pressure sensor 30 detects a pressure signal, the first pressure sensor 30 may transmit the detected pressure signal to the first signal transmission socket 12 via the jack of the first connection wire. That is, the pressure signal may be connected to the signal transmission pin of the first signal transmission socket 12 via the signal transmission pin of the jack of the first connection wire. Similarly, if the second pressure sensor 40 detects a pressure signal, the second pressure sensor 40 may transmit the detected pressure signal to the second signal transmission socket 12 via the jack of the second connection wire.

### Embodiment 2

The embodiment 2 may be similar to the embodiment 1, except that the first pressure sensor 30 may include a first connection wire, and the second pressure sensor 40 may include a second connection wire. An end of each of the first connection wire and the second connection wire may be connected to a jack matching the signal transmission socket 12. That is, the first connection wire and the second connection wire may share one jack. The lock circuit board 10 may have one signal transmission socket 12. The integrated design may reduce the occupied space, the overall space, and the cost of the lock circuit board 10.

Furthermore, in the embodiment 1 and/or embodiment 2, the processing chip may include a sensor signal acquisition module. The sensor signal acquisition module may be connected to a corresponding pin of the signal transmission socket 12 via a lead wire. Alternatively, the sensor signal acquisition module may be an external device of the processing chip, and the sensor signal acquisition module may be connected to the signal transmission pin of the processing chip to realize signal transmission.

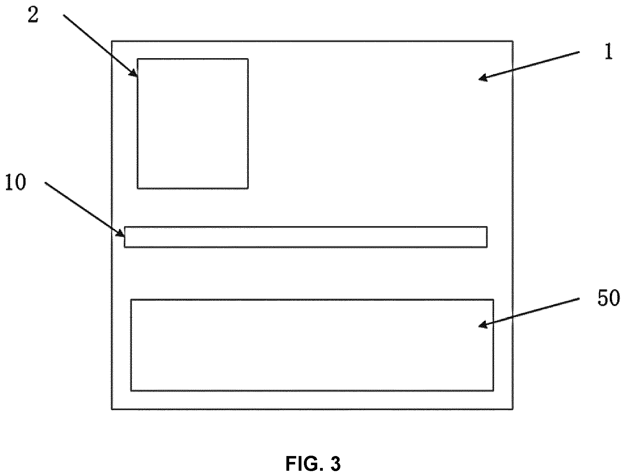

In some embodiments, as shown in FIG. 3, the lock motor 20, the first pressure sensor 30, and the second pressure sensor 40 may be disposed at a front end of the lock control box. The lock circuit board 10 may be vertically disposed at the middle end of the lock control box. The power source 50 may include a battery pack disposed at a rear end of the lock control box. The control socket 11 and the signal transmission socket 12 may be disposed on a front surface of the lock circuit board. The power source 50 socket 13 may be disposed on a rear surface of the lock circuit board.

Further, the lock circuit board 10 may include a double-sided circuit board or a multi-layer circuit board. Functional module(s) of the lock circuit board 10 may be integrally designed, thereby improving the stability and reducing the power loss of the circuit.

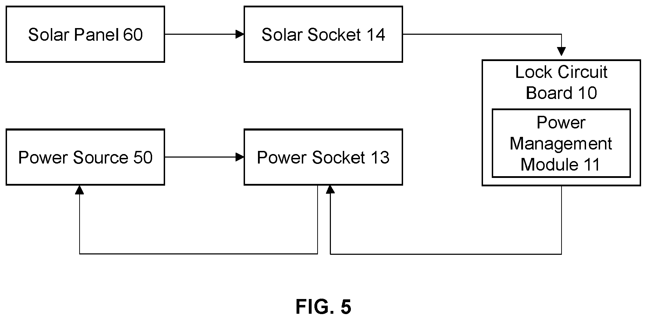

As shown in FIG. 5, a preferred embodiment of a socket structure based on a solar socket 14 is provided according to the present disclosure.

The socket structure may include the solar socket 14 disposed on the front surface of the lock circuit board 10. The solar socket 14 may be connected to an external solar panel 60. The solar socket 14 may be connected to a power management module 11 of the lock circuit board 10. The power management module 15 may be connected to a battery and configured to power the battery using an electric power of the solar panel 60.

Further, the solar socket 14 may include a signal transmission pin connected to a main control chip of the lock circuit board 10. The solar battery and a detection line may share a data line. An end of the data line may include a jack that matches the solar socket.

The above description is provided with respect to some preferred embodiments of the present disclosure, and not intended to limit the scope of the present disclosure. Multiple variations or modifications may be made under the teachings of the present disclosure. However, those variations and modifications do not depart from the scope of the present disclosure.

## Claims

1. A socket structure of a lock circuit board of a shared bicycle, the lock circuit board being disposed in a lock control box, and connected to a power source, a lock motor, a first pressure sensor, and a second pressure sensor via wires respectively, wherein
the socket structure comprises a control socket, a signal transmission socket, and a power socket disposed on the lock circuit board,
the control socket is configured to connect the lock motor to a control line of the lock circuit board,
the power socket is configured to connect the power source to a power input of the lock circuit board, and
the signal transmission socket is configured to connect the lock circuit board to the first pressure sensor and the second pressure sensor, respectively.

2. The socket structure of claim 1, wherein:
the signal transmission socket includes a first signal transmission socket and a second signal transmission socket;
the first pressure sensor includes a first connection wire, one end of the first connection wire has a jack matching the first signal transmission socket, and the first pressure sensor is connected with the first signal transmission socket via the jack of the first connection wire; and
the second pressure sensor includes a second connection wire, one end of the second connection wire has a jack matching the second signal transmission socket, and the second pressure sensor is connected with the second signal transmission socket via the jack of the second connection wire.

3. The socket structure of claim 1, wherein the first pressure sensor includes a first connection wire, the second pressure sensor includes a second connection wire, and an end of each of the first connection wire and the second connection wire is connected to a jack matching the signal transmission socket.

4. The socket structure of claim 3, wherein a sensor signal acquisition module of the lock circuit board is connected to a corresponding pin of the signal transmission socket via a lead wire.

5. The socket structure of claim 1, wherein:
the lock motor, the first pressure sensor, and the second pressure sensor are disposed at a front end of the lock control box,
the lock circuit board is vertically disposed at the middle end of the lock control box,
the power source includes a battery pack disposed at a rear end of the lock control box,
the control socket and the signal transmission socket are disposed on a front surface of the lock circuit board, and
the power socket is disposed on a rear surface of the lock circuit board.

6. The socket structure of claim 5, wherein:
the socket structure further comprises a solar socket disposed on the front surface of the lock circuit board,
the solar socket is connected to an external solar panel,
the solar socket is connected to a power management module of the lock circuit board, and
the power management module is connected to a battery and configured to power the battery using an electric power of the solar panel.

7. The socket structure of claim 6, wherein:
the solar socket further comprises a signal transmission pin connected to a main control chip of the lock circuit board,
the solar battery and a detection line share a data line, and
an end of the data line includes a jack that matches the solar socket.
